# EUROPÄISCHE PATENTSCHRIFT

(11) **EP 4 100 751 B1**
(45) Veröffentlichungstag und Bekanntmachung des Hinweises auf die Patenterteilung: **10.01.2024**
(21) Anmeldenummer: 21717795.5
(22) Anmeldetag: 02.04.2021
(51) Int. Cl.: G01R 31/28

(54) **UMSCHALTBARER VERSTÄRKER**
SWITCHABLE AMPLIFIER
AMPLIFICATEUR COMMUTABLE

(30) Priorität: 03.04.2020 AT 502872020
(43) Veröffentlichungstag der Anmeldung: 14.12.2022
(73) Patentinhaber: Omicron electronics GmbH, 6833 Klaus (AT)
(72) Erfinder: PÉREZ DE AYALA RULL, Pedro, 58050 Madrid (ES); DENZ, Patrick, 6845 Hohenems (AT)
(74) Vertreter: Patentanwälte Pinter & Weiss OG
(86) Internationale Anmeldenummer: PCT/EP2021/058791
(87) Internationale Veröffentlichungsnummer: WO 2021/198505

(56) Entgegenhaltungen:
- EP-A1- 0 613 242
- EP-B1- 3 114 763
- CN-A- 107 015 081
- CN-A- 109 687 715

## Beschreibung

Die gegenständliche Erfindung betrifft einen Verstärker für ein Prüfgerät, welches zum Prüfen einer elektrischen Komponente geeignet ist, wobei der Verstärker ausgestaltet ist ein Prüfsignal an einem Signalausgang zwischen einem positiven Ausgangsanschluss und einem negativen Ausgangsanschluss auszugeben, wobei der Verstärker eine erste Halbbrücke, welche ein erstes Schaltelement und ein über einen ersten Mittelpunkt mit dem ersten Schaltelement in Serie geschaltetes zweites Schaltelement aufweist, und eine zweite Halbbrücke, welche ein drittes Schaltelement und ein über einen zweiten Mittelpunkt mit dem dritten Schaltelement in Serie geschaltetes viertes Schaltelement aufweist, umfasst.

Oftmals sind Prüfgeräte zur Prüfung von Steuervorrichtungen von elektromechanischen oder elektronischen Schaltvorrichtungen notwendig. Speziell im Bereich der elektrischen Schutztechnik und elektrischen Energieversorgung ist die Prüfung der Funktion von Schaltvorrichtungen und deren Steuervorrichtungen wichtig und oftmals sogar vorgeschrieben. Beispielsweise sind in elektrischen Mittelspannungsnetzen an Masten montierte Schaltvorrichtungen oft mit elektro-magnetischen Aktuatoren ausgestattet und über Steuerverbindungen mit Steuervorrichtungen verbunden. Üblicherweise wird ein Prüfgerät verwendet, das die Schaltvorrichtung simulieren soll. Dazu wird die Schaltvorrichtung und die Steuerverbindung von der Steuervorrichtung getrennt und stattdessen ein Prüfgerät über ein Adapterkabel an die Steuervorrichtung angeschlossen, um deren Funktion zu prüfen. Das Prüfgerät erzeugt dann ein entsprechendes elektrisches Prüfsignal, welches die Steuervorrichtung zu bestimmten Reaktionen anregen sollen. Die Reaktionen werden vom Prüfgerät erfasst und ausgewertet.

Ein Prüfsignal setzt sich aus einem Prüfstrom und einer Prüfspannung zusammen. Das Prüfsignal kann eine hohe Prüfspannung, beispielsweise im Bereich von 300 V, und einen geringen Prüfstrom, beispielsweise im Bereich von 1 A aufweisen. Hierzu ist im Prüfgerät ein Spannungsverstärker vorgesehen, welcher ausgestaltet ist ein Prüfsignal mit einer hohen Prüfspannung und einem geringen Prüfstrom zu erzeugen. Alternativ kann das Prüfsignal auch einen hohen Prüfstrom, beispielsweise im Bereich von 30 A, und einer kleinen Prüfspannung, beispielsweise im Bereich von 25 V, vorgesehen sein. Hierzu ist wiederum ein Stromverstärker vorgesehen, welcher ausgestaltet ist ein Prüfsignal mit einem hohen Prüfstrom und einer geringen Prüfspannung zu erzeugen. Da entweder eine hohe Prüfspannung und ein geringer Prüfstrom oder ein hoher Prüfstrom und eine geringe Prüfspannung ausgegeben wird, ergibt sich eine verhältnismäßig geringe Leistungsabgabe.

Sind ein Stromverstärker und ein Spannungsverstärker in einem Prüfgerät vorgesehen, so weisen diese unterschiedliche, voneinander getrennte, Topologien auf. Für den Spannungsverstärker ist ein spezieller Spannungsausgang (umfassend einen positiven Spannungsausgangsanschluss und einen negativen Spannungsausgangsanschluss) und für den Stromverstärker ein spezieller, vom Spannungsausgang getrennter, Stromausgang (umfassend einen positiven Stromausgangsanschluss und einen negativen Stromausgangsanschluss) vorgesehen. Da weder am Stromausgang, noch am Spannungsausgang ein Prüfsignal mit gleichzeitig hoher Prüfspannung und hohem Prüfstrom ausgegeben wird, wird sowohl am Spannungsausgang, als auch am Stromausgang eine verhältnismäßig geringe Leistung abgegeben. Dennoch müssen der Stromverstärker, als auch der Spannungsverstärker ausreichend robust dimensioniert sein, um den hohen Prüfstrom oder die hohe Prüfspannung ausgeben zu können. Weist ein Prüfgerät einen Spannungsverstärker und einen Stromverstärker auf, so ist das Prüfgerät nicht nur entsprechend voluminös, sondern auch schwer, was sich natürlich negativ auf die Portabilität auswirkt. Dies ist nachteilig, da eine Prüfung von Steuervorrichtungen einer Schaltvorrichtung in der Regel im Feld vor Ort stattfindet, womit eine hohe Mobilität erwünscht ist.

Aus der Schrift CN 109 687 715 A ist ein DC-DC-Wandler, insbesondere ein Resonanzwandler mit einem Transformator, sowie ein zugehöriges Steuerverfahren bekannt, durch welches eine Verstärkerbereich verbessert wird. Dazu sind primärseitig zwei Relaisschalter vorgesehen, mit welchen in Abhängigkeit von einer Ausgangsspannung des Resonanzwandlers, welche dazu mit einem vorgegebenen Vergleichswert verglichen wird, zwischen einer eingangsseitigen Vollbrückenschaltung und einer eingangsseitigen Halbbrückenschaltung umgeschaltet werden kann.

Es ist eine Aufgabe der gegenständlichen Erfindung, einen leichten und robusten Spannungsverstärker und Stromverstärker für ein Prüfgerät anzugeben.

Diese Aufgabe wird erfindungsgemäß gelöst, indem im Verstärker eine Umschalteinheit vorgesehen ist, welche ausgestaltet ist, in einem ersten Betriebsmodus den ersten Mittelpunkt der ersten Halbbrücke mit dem zweiten Mittelpunkt der zweiten Halbbrücke zu verbinden und auf einen der Ausgangsanschlüsse des Signalausgangs zu schalten und in einem zweiten Betriebsmodus den ersten Mittelpunkt der ersten Halbbrücke und den zweiten Mittelpunkt der zweiten Halbbrücke auf jeweils einen der Ausgangsanschlüsse des Signalausgangs zu schalten. Weiterhin ist der Verstärker ausgestaltet, im ersten Betriebsmodus die erste Halbbrücke mit Steuersignalen anzusteuern, welcher gegenüber Steuersignalen zur Ansteuerung der zweiten Halbbrücke um 180 Grad phasenverschoben sind, und im zweiten die erste Halbbrücke und die zweite Halbbrücke mit phasengleichen Steuersignalen anzusteuern.

Der erste Betriebsmodus ist für die Ausgabe eines Prüfsignals mit einem hohen Prüfstrom optimiert, womit der Verstärker im ersten Betriebsmodus als Stromverstärker angesehen werden kann. Im ersten Betriebsmodus kann der Verstärker somit am Signalausgang durch eine Parallelschaltung der ersten Halbbrücke und der zweiten Halbbrücke ein Prüfsignal mit einem hohen Prüfstrom, beispielsweise im Bereich von 25 bis 50 A und mit einer geringen oder vernachlässigbaren Prüfspannung, beispielsweise im Bereich von 0 bis 25 V, ausgeben.

Der zweite Betriebsmodus ist für die Ausgabe eines Prüfsignals mit einer hohen Prüfspannung optimiert, womit der Verstärker im zweiten Betriebsmodus als Spannungsverstärker angesehen werden kann. Somit kann der Verstärker im ersten Betriebsmodus durch eine Serienschaltung der ersten Halbbrücke und der zweiten Halbbrücke am Signalausgang ein Prüfsignal mit einer hohen Prüfspannung, beispielsweise im Bereich von 50 V - 10 kV, und einem geringen und/oder vernachlässigbaren Prüfstrom, beispielsweise im Bereich von 0 bis 1 A, ausgeben.

Dadurch wird durch den erfindungsgemäßen, vom ersten in den zweiten Betriebsmodus und umgekehrt umschaltbaren, Verstärker je nach Betriebsmodus sowohl ein Stromverstärker, als auch ein Spannungsverstärker realisiert. Es kann an einem Signalausgang, d.h. zwischen einem positiven Ausgangsanschluss und einem negativen Ausgangsanschluss, je nach Betriebsmodus ein Prüfsignal mit einer hohen Prüfspannung und einem geringen Prüfstrom oder mit einem hohen Prüfstrom und einer geringen Prüfspannung ausgegeben werden. Der erfindungsgemäße Verstärker erlaubt also im ersten und im zweiten Betriebsmodus eine Nutzung desselben Signalausgangs. Prüfgeräte nach dem Stand der Technik, d.h. mit getrennten Spannungsverstärkern und Stromverstärkern, weisen hingegen getrennte Spannungsausgänge und Stromausgänge auf. Es ist natürlich auch möglich im erfindungsgemäßen Verstärker getrennte Signalausgänge für den erste und zweiten Betriebsmodus vorzusehen, was jedoch einen zusätzlichen Schaltungsaufwand bedeuten würde. Da erfindungsgemäß für beide Betriebsmodi eine gemeinsame Schaltungstopologie vorgesehen ist, sind weniger Bauteile erforderlich, als es bei einer getrennten Ausgestaltung eines Spannungsverstärker und Stromverstärkers der Fall ist. Damit sind das Volumen und die Masse des umschaltbaren Verstärkers geringer, was eine höhere Portabilität bedeutet.

Dabei umfasst - wie eingangs ausgeführt - die erste Halbbrücke des Verstärkers, ein erstes Schaltelement und ein, in Serie zum ersten Schaltelement geschaltetes, zweites Schaltelement, und die zweite Halbbrücke, ein drittes Schaltelement und ein, in Serie zum dritten Schaltelement geschaltetes, viertes Schaltelement. Natürlich können in der erste und/oder zweiten Halbbrücke auch weitere Schaltelemente vorgesehen sein, z.B. um die am Ausgang abgebbare Leistung zu erhöhen.

Vorzugsweise umfasst der Verstärker eine erste Gleichspannungsquelle und eine über einen Verbindungspunkt in Serie geschaltete zweite Gleichspannungsquelle, wobei die erste und zweite Halbbrücke jeweils parallel zu den in Serie geschalteten ersten und zweiten Gleichspannungsquellen geschaltet sind und ein Verbindungspunkt des ersten Schaltelements und des zweiten Schaltelements einen ersten Mittelpunkt und ein Verbindungspunkt des dritten Schalelements und des vierten Schaltelements einen zweiten Mittelpunkt ausbildet, wobei der erste Mittelunkt mit dem positiven Ausgangsanschluss verbunden ist.

Weiterhin kann im ersten Betriebsmodus der zweite Mittelpunkt mit dem positiven Ausgangsanschluss verbunden und vom negativen Ausgangsanschluss getrennt sein, sowie der Verbindungspunkt mit dem negativen Ausgangsanschluss verbunden sein, um die erste Halbbrücke und die zweite Halbbrücke parallel auf den Signalausgang zu schalten. Damit kann am Signalausgang ein Prüfsignal mit einem hohen Prüfstrom ausgegeben werden.

Weiters kann am Signalausgang eine Filterinduktivität vorgesehen sein, deren Induktivität vorzugsweise umschaltbar ist. Die Filterinduktivität kann in Serie zum positiven Ausgangsanschluss oder zum negativen Ausgangsanschluss geschaltet sein. Vorzugweise wird die Induktivität der Filterinduktivität im ersten Betriebsmodus auf eine geringere Induktivität, z.B. 10 µH, und im zweiten Betriebsmodus auf eine höhere Induktivität, z.B. 200 µH, geschaltet. Dies kann über eine Mittelanzapfung der Filterinduktivität erfolgen. Dadurch kann im zweiten Betriebsmodus durch die höhere Induktivität der Rippel des Prüfsignals klein gehalten werden. Es kann auch vorgesehen sein, dass eine Filterinduktivität nur im ersten Betriebsmodus mit dem Signalausgang verbunden ist und im zweiten Betriebsmodus vom Signalausgang getrennt, z.B. überbrückt, wird. Im zweiten Betriebsmodus wird grundlegend die Prüfspannung des Prüfsignals geregelt, womit insbesondere hochohmige Lasten mit dem Signalausgang verbunden werden können. Wird die Filterinduktivität im zweiten Betriebsmodus mit dem Signalausgang verbunden, so kann im zweiten Betriebsmodus der Prüfstrom des Prüfsignals einfacher geregelt werden da durch die Filterinduktivität der Prüfstrom geglättet wird. Damit können nicht nur niederohmige Lasten, sondern aufgrund der hohen treibenden Ausgangsspannung auch hochohmige Lasten getrieben werden. Die Filterinduktivität ist optional, wirkt sich jedoch günstig auf das Regelverhalten und die Signalqualität des Ausgangssignals aus.

Vorzugsweise ist im zweiten Betriebsmodus der negative Ausgangsanschluss vom Verbindungspunkt getrennt und mit dem zweiten Mittelpunkt verbunden. Damit wird die erste Halbbrücke und die zweite Halbbrücke in Serie geschaltet und ein Prüfsignal mit einer hohen Spannung am Signalausgang ausgegeben werden.

Es kann im zweiten Betriebsmodus die Verbindung des zweiten Mittelpunkts mit dem negativen Ausgangsanschluss über einen ersten Umschalter, welcher von der Umschalteinheit angesteuert wird, erfolgen.

Der erfindungsgemäße Verstärker kann in einem Prüfgerät zum Prüfen einer elektrischen Komponente, vorzugsweise einer Steuervorrichtung einer Schaltvorrichtung, einer elektrischen Schaltanlage verwendet werden. Hierzu kann das Prüfsignal an die elektrische Komponente angelegt werden, um eine Prüfung zu ermöglichen. Das Prüfgerät kann weiters ein Eingangssignal empfangen um die elektrische Komponente zu prüfen. Die Prüfung der Funktion der elektrischen Komponente kann aber auch unabhängig vom Prüfgerät erfolgen.

So kann beispielsweise ein Prüfgerät zur Prüfung von Energiezählern vorgesehen sein. Ein Energiezähler misst über einen vorgegebenen Zeitraum einen Strom und eine Spannung um die verbrauchte Energie korrekt bestimmen zu können. Die Energiezähler verfügen meist über ein Rollenzählwerk oder liefern Zählimpulse z.B. über eine LED mit z.B. 1000 Impulsen/kWh. Die Genauigkeit des Energiezählers kann unter Verwendung eines Prüfgeräts bewertet werden. Dies kann erfolgen, indem der Verstärker des Prüfgeräts das Prüfsignals ausgibt, um über eine vorgegebene Zeit Ströme und/oder Spannungen, z.B. analoge Sekundärgrößen von Strom- und/oder Spannungswandlern simuliert. Diese Ströme und/oder Spannungen, d.h. das Prüfsignal, werden einerseits dem Energiezähler zugeführt, jedoch andererseits auch direkt aufgezeichnet und daraus die tatsächlich abgegebene Energie berechnet. Es kann zusätzlich oder statt der Aufzeichnung der Ströme und/oder Spannungen die vom Prüfgerät abgegebene Energie auch direkt aufgezeichnet werden. Der Energiezähler ermittelt aus den Strömen und/oder Spannungen ebenso die Energie, woraufhin die tatsächlich abgegebene, d.h. aufgezeichnete oder berechnete, Energie mit der durch den Energiezähler ermittelten Energie verglichen wird. Dadurch kann die Genauigkeit des Energiezählers bestimmt werden. Die Bestimmung selbst kann durch eine Vergleichseinheit erfolgen, welche die abgegebene Energie mit der ermittelten Energie vergleicht. Die Vergleichseinheit kann am Prüfgerät selbst oder als eigenständige Komponente oder eigenständiges Gerät vorgesehen sein. Natürlich kann der Vergleich auch durch einen Nutzer erfolgen.

Weiters kann durch ein Prüfgerät, umfassend einen erfindungsgemäßen Verstärker, ein Sekundärsignal von Betriebsmitteln (Wandler, Schutzrelais) einer elektrischen Anlage geprüft werden. Hierzu wird durch den Verstärker des Prüfgeräts ein Prüfsignal ausgegeben, welches als Primärsignal verwendet wird. Das Primärsignal wird auf einer Primärseite des Betriebsmittels angelegt und weiters das Sekundärsignal auf der Sekundärseite des Betriebsmittels ermittelt. Das Sekundärsignal kann auf die korrekte Polarität, den korrekten Pegel, etc. überprüft werden, womit beispielsweise die sekundärseitige Verdrahtung geprüft werden kann. Die Analyse des Sekundärsignals kann durch eine Analyseeinheit erfolgen, welche am Prüfgerät selbst oder als eigenständige Komponente oder Gerät vorgesehen ist. Natürlich kann die Analyse auch durch einen Nutzer erfolgen.

Die gegenständliche Erfindung wird nachfolgend unter Bezugnahme auf die Figuren 1 bis 5c näher erläutert, die beispielhaft, schematisch und nicht einschränkend vorteilhafte Ausgestaltungen der Erfindung zeigen. Dabei zeigt
- Fig.1a: eine elektrische Schaltanlage mit einer Steuereinheit,
- Fig.1b: ein mit der Steuereinheit verbundenes Prüfgerät,
- Fig. 2: eine Ausgestaltung des Verstärkers,
- Fig. 3a: den Verstärker im ersten Betriebsmodus,
- Fig. 3b: den Verstärker im zweiten Betriebsmodus,
- Fig. 3c: den Verstärker im zweiten Betriebsmodus mit einer Filterinduktiviät Lx am Ausgang,
- Fig. 4a: ein Prüfsignal im ersten Betriebsmodus bei einem Tastgrad von 50%,
- Fig. 4b: ein Prüfsignal im ersten Betriebsmodus bei einem Tastgrad von 40%,
- Fig. 5a: ein Prüfsignal im zweiten Betriebsmodus bei einem Tastgrad von 50%,

- Fig. 5b: ein Prüfsignal im zweiten Betriebsmodus bei einem Tastgrad von 40%,
- Fig. 5c: ein Prüfsignal im zweiten Betriebsmodus bei einem Tastgrad von 60%.

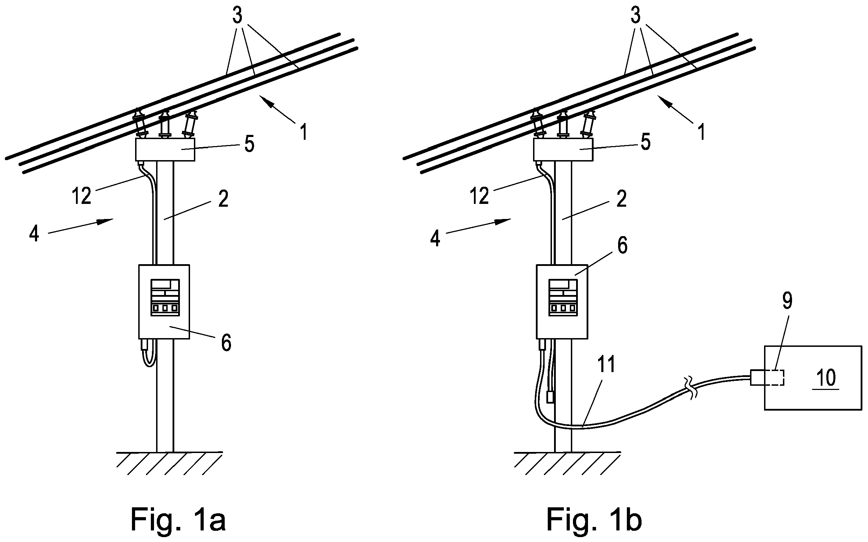

In Fig.1 ist ein Teil eines elektrischen Versorgungsnetzes 1, hier eine dreiphasige Freileitung, deren Leitungen 3 in herkömmlicher Weise zwischen Masten 2 gespannt sind, dargestellt. Am Mast ist als Sicherheitseinrichtung eine Schaltanlage 4 vorgesehen, die aus einer Schaltvorrichtung 5 und einer zugehörigen Steuervorrichtung 6 besteht. Die Schaltvorrichtung 5 ist beispielsweise in bekannter Weise ein Recloser oder ein Leistungsschalter in Form eines magnetischen Aktuators, der eine Spule beinhaltet. Die Schaltvorrichtung 5 ist in der Lage, durch eine von der Steuervorrichtung 6 ausgelöste Schalthandlung, zumindest eine der Leitungen 3 zu trennen oder zu verbinden.

Die Schaltvorrichtung 5 ist hierzu über eine Steuerverbindung 12 mit der Steuervorrichtung 6 verbunden. Die Steuerverbindung 12 umfasst hierzu in der Regel eine Anzahl von Steuerleitungen zur Übermittlung von Steuereingangsgrößen und Steuerausgangsgrößen. Durch Steuerausgangsgrößen werden typischerweise Schalthandlungen ausgelöst.

Zum Prüfen der Schaltanlage 4 wird die Steuerverbindung 12 zwischen der Schaltvorrichtung 5 und der Steuervorrichtung 6 getrennt, wie in Fig.1b dargestellt. Es ist auch möglich, dass die Schaltvorrichtung 5 vor der Prüfung gar nicht mit der Steuervorrichtung 6 verbunden ist, beispielsweise bei einer Erstinbetriebnahme, womit das Trennen der Steuerverbindung 12 entfallen kann. Das ist recht häufig der Fall, da die Steuervorrichtung 6 oft vor einer Installation parametriert und anschließend mit dem Prüfgerät 10 auf Funktion getestet werden, bevor diese "ins Feld" gebracht und installiert werden. Die Steuervorrichtung 6 wird zur Prüfung mit einem Adapterkabel 11 mit einem Prüfgerät 10 verbunden, welches die Schaltvorrichtung 5 simuliert, um die ordnungsgemäße Funktion und Parametrierung der Steuervorrichtung 6 der Schaltanlage 4 prüfen zu können. Das Adapterkabel 11 wird mit einer Seite an den Signaleingang der Steuervorrichtung 6 und mit der anderen Seite an den Signalausgang 9 des Prüfgeräts 10 angeschlossen. Das Prüfgerät 10 dient somit dazu, die Schaltvorrichtung 5 nachzubilden bzw. zu simulieren. Zum Nachweis der korrekten Funktionsweise der Steuervorrichtung 6 können (beispielsweise dreiphasige) analoge Sekundärgrößen von Strom- und/oder Spannungswandlern durch das Prüfgerät 10 simuliert und in die Steuereinheit 6 eingespeist werden. Die Steuervorrichtung 6 übermittelt je nach Fehlerart und Fehlerausprägung nach einer vorgegebenen Zeit, z.B. durch einen Binärkontakt, ein Signal zur Trennung zumindest einer der Leitungen 3 an das Prüfgerät 10. Dabei simuliert das Prüfgerät 10 die Schaltvorrichtung 5. Die Erzeugung der Sekundärgrößen, welche in die Steuervorrichtung 6 eingespeist werden, kann durch ein Prüfgerät 10 umfassend einen erfindungsgemäßen Verstärker erfolgen. Damit dient ein Prüfsignal als Sekundärgröße.

Ein Prüfgerät 10 umfassend einen erfindungsgemäßen Verstärker 8 ist natürlich nicht auf die Anwendung in einem elektrischen Versorgungsnetz 1 in Form einer Freileitung beschränkt, sondern kann in jeder Anlage zur Übertragung oder Verteilung von elektrischer Energie mit Sicherheitseinrichtungen in Form einer Schaltanlage 4 mit einer Schaltvorrichtung 5 und einer zugehörigen Steuervorrichtung 6 verwendet werden. Der erfindungsgemäße Verstärker 8 kann auch in einem Prüfgerät 10 zum Prüfen einer elektrischen Komponente einer elektrischen Schaltanlage verwendet werden, wobei das Prüfsignal an die elektrische Komponente angelegt wird.

Ein Verstärker 8 für ein Prüfgerät 10 zum Prüfen einer elektrischen Komponente, vorzugsweise einer Steuervorrichtung 6 einer Schaltvorrichtung 5 einer elektrischen Schaltanlage 4, ist ausgestaltet, ein Prüfsignal an einem Signalausgang zwischen einem positiven Ausgangsanschluss P und einen negativen Ausgangsanschluss N auszugeben. Es ist im Verstärker 8 erfindungsgemäß eine Umschalteinheit 7 vorgesehen, welche ausgestaltet ist den Verstärker 8 wahlweise in einen ersten Betriebsmodus Mi und in einen zweiten Betriebsmodus Mu zu schalten.

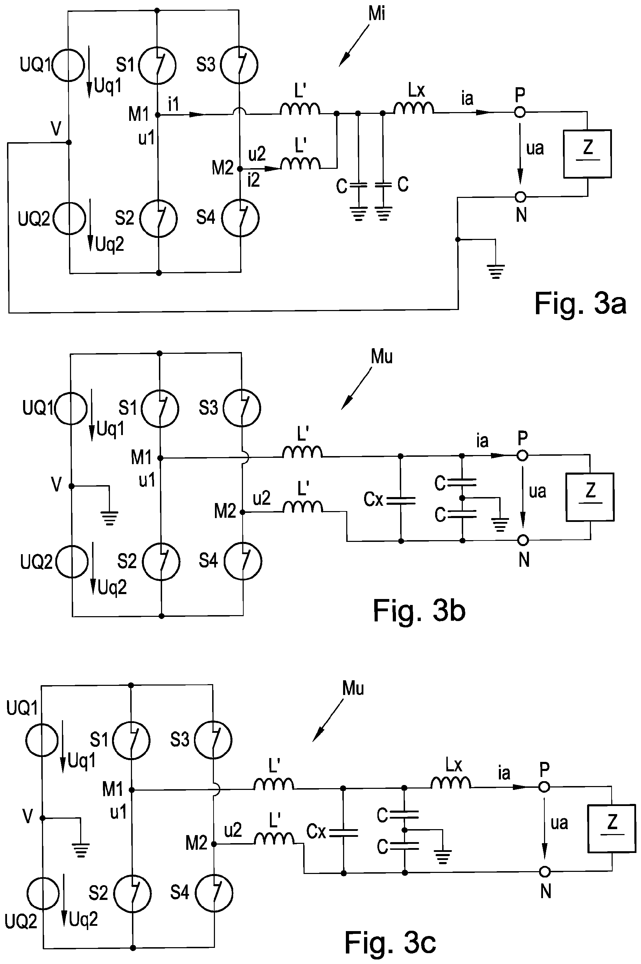

Das Prüfsignal setzt sich aus einem Prüfstrom ia und einer Prüfspannung ua zusammen. Im ersten Betriebsmodus Mi wird vorzugsweise der Prüfstrom ia des Prüfsignals geregelt, im zweiten Betriebsmodus Mu vorzugsweise die Prüfspannung ua des Prüfsignals. In Fig. 3 ist eine Ausgestaltung des Verstärkers 8 dargestellt. Dabei ist eine erste Halbbrücke HB1, umfassend ein erstes Schaltelement S1 und ein in Serie zum ersten Schaltelement S1 geschaltetes zweites Schaltelement S2, eine zweite Halbbrücke HB2, umfassend ein drittes Schaltelement S3 und ein in Serie zum dritten Schaltelement S3 geschaltetes, viertes Schaltelement S4, vorgesehen.

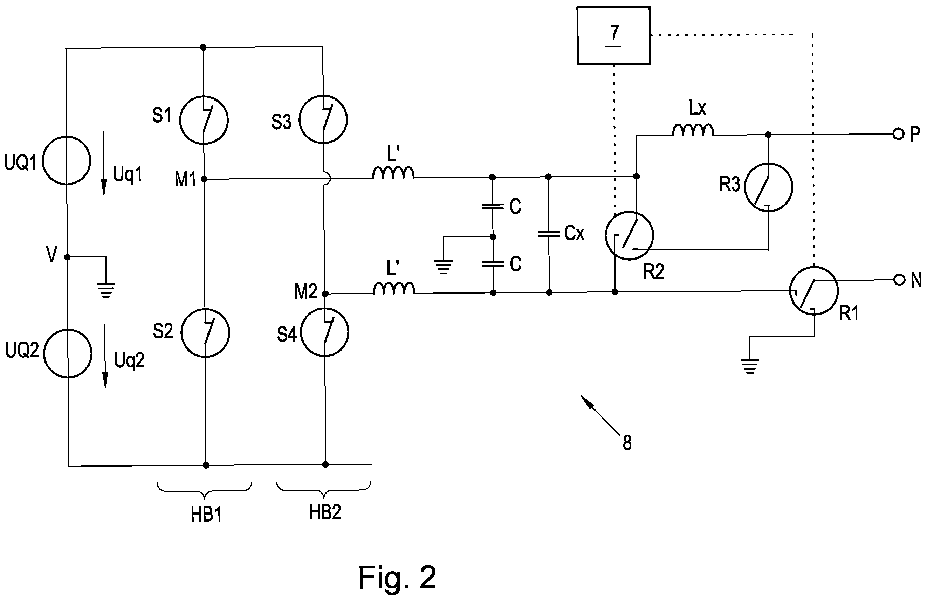

Der Signalausgang ist mit einer Last Z verbunden, vorzugsweise im ersten Betriebsmodus Mi mit einer niederohmigen Last Z und im zweiten Betriebsmodus Mu mit einer hochohmigen Last Z. Als Last L kann eine weitere elektrische Komponente, beispielsweise die Steuervorrichtung 6 der Schaltvorrichtung 5 der elektrischen Schaltanlage 4 entsprechend Fig. 1, angesehen werden. Im ersten Betriebsmodus Mi werden die erste Halbbrücke HB1 und die zweite Halbbrücke HB2 parallel auf den Signalausgang geschaltet, im zweiten Betriebsmodus Mu werden die erste Halbbrücke HB1 und die zweite Halbbrücke HB2 in Serie auf den Signalausgang geschaltet. Im dargestellte Ausführungsbeispiel sind im Verstärker 8 eine erste Gleichspannungsquelle UQ1 mit einer ersten Gleichspannung Uq1 und eine über einen Verbindungspunkt V in Serie geschaltete zweite Gleichspannungsquelle UQ2 mit einer zweiten Gleichspannung Uq2 vorgesehen. Die erste Halbbrücke HB1 und die zweite Halbbrücke HB2 sind weiters jeweils parallel zu den in Serie geschalteten ersten und zweiten Gleichspannungsquellen UQ1, UQ2 geschaltet, wobei ein Verbindungspunkt des ersten Schaltelements S1 und des zweiten Schaltelements S2 einen ersten Mittelpunkt M1 und ein Verbindungspunkt des dritten Schalelements S3 und des vierten Schaltelements S4 einen zweiten Mittelpunkt M2 ausbilden. Zudem ist der erste Mittelunkt M1 mit dem positiven Ausgangsanschluss P verbunden, was direkt erfolgen kann, oder über weitere Elemente. Als weitere Elemente können insbesondere Leitungsfilterinduktivitäten L` vorgesehen sein. Dies ist in den Fig. 2 (und auch Fig. 3a, b, c) der Fall, da ist zwischen den ersten Mittelpunkt M1 und den positiven Ausgangsanschluss P eine optionale Leitungsfilterinduktivität L` vorgesehen ist. Ebenso ist in den Fig. 2 (und Fig. 3a, b, c) zwischen dem zweiten Mittelpunkt M2 und dem negativen Ausgangsanschluss N eine optionale Leitungsfilterinduktivität L` vorgesehen. Die Leitungsfilterinduktivitäten L' sind zudem jeweils über optionale Leitungsfilterkapazitäten C mit Masse verbunden. Wird auf die Leitungsfilterinduktivitäten L` verzichtet und sind dennoch Leitungsfilterkapazitäten C vorgesehen, so sind der erste und zweite Mittelpunkt M1, M2 jeweils über die Leitungsfilterkapazitäten C mit Masse verbunden.

Weiters ist am Signalausgang eine Filterinduktivität L vorgesehen, deren Induktivität durch einen zweiten Umschalter R2 umschaltbar oder überbrückbar ist. Vorzugsweise ist die Filterinduktivität im ersten Betriebsmodus Mi durch den zweiten Umschalter R2 überbrückt. Es ist jedoch ebenso ein optionaler dritter Umschalter R3 vorgesehen, welcher dazu dient, die Filterinduktivität L im zweiten Betriebsmodus Mu wieder zuzuschalten. Natürlich kann die Filterinduktivität L zweiten Betriebsmodus auch Mu durch einen vom zweiten Umschalter R2 getrennt ausgeführten weiteren Umschalter (nicht dargestellt) zugeschaltet werden.

Wird im zweiten Betriebsmodus Mu eine Filterinduktivität L zugeschaltet, so kann auch zweiten Betriebsmodus Mu eine niederohmige Last Z mit dem Signalausgang verbunden werden. Wird angenommen, dass der Verstärker 8 im zweiten Betriebsmodus Mu ein Prüfsignal mit einem Prüfstrom ia von 1A ausgeben kann, so kann beispielsweise eine Last Z mit 300 Ohm am Signalausgang vorgesehen sein, da die Spannungsquellen UQ1 und UQ2 eine ausreichend hohe Gleichspannung Uq1, Uq2 bereitstellen, um diese Last zu treiben.

Es ist in Fig. 2 weiters eine optionale Filterkapazität Cx zwischen dem den positiven Ausgangsanschluss P und den negativen Ausgangsanschluss N vorgesehen. Der zweite Umschalter R2 dient in der dargestellten Ausgestaltung auch dazu, im zweiten Betriebsmodus Mu eine Filterkapazität Cx zwischen den positiven Ausgangsanschluss P und den negativen Ausgangsanschluss N zu schalten und die Filterkapazität Cx im ersten Betriebsmodus Mi zu überbrücken.

Der erste Umschalter R1 und/oder zweite Umschalter R2 und/oder dritte Umschalter R3 und/oder weitere Umschalter kann durch die Umschalteinheit 7 angesteuert werden. Die Filterinduktivität Lx befindet sich somit zwischen dem ersten Mittelpunkt M1 und dem positiven Ausgangsanschluss P (wie in den Figuren dargestellt).

Es ist auch vorstellbar, dass die Filterinduktivität Lx zwischen dem zweiten Mittelpunkt M2 und dem negativen Ausgangsanschluss N angeordnet ist. Es kann auch je eine Filterinduktivität Lx zwischen dem ersten Mittelpunkt M1 und dem positiven Ausgangsanschluss P und zwischen dem zweiten Mittelpunkt M2 und dem negativen Ausgangsanschluss N vorgesehen sein. Im ersten Betriebsmodus Mi ist der zweite Mittelpunkt M2 vom negativen Ausgangsanschluss N getrennt und der Verbindungspunkt V mit dem negativen Ausgangsanschluss N verbunden, um die erste Halbbrücke HB1 und die zweite Halbbrücke HB2 parallel auf den Signalausgang zu schalten und am Signalausgang das ein Prüfsignal mit einem hohen Prüfstrom ia auszugegeben.

Es könnte stattdessen im ersten Betriebsmodus Mi auch der erste Mittelpunkt M1 vom positiven Ausgangsanschluss P getrennt werden, wobei der Verbindungspunkt V mit dem positiven Ausgangsanschluss P verbunden wird, um die erste Halbbrücke HB1 und die zweite Halbbrücke HB2 parallel auf den Signalausgang zu schalten und am Signalausgang ein Prüfsignal mit einem hohen Prüfstrom ia auszugegeben. In diesem Fall ist es vorteilhaft, wenn zwischen dem zweiten Mittelpunkt M2 und dem negativen Ausgangsanschluss N eine Filterinduktivität Lx vorgesehen ist.

Ein Umschalten der Verbindung des zweiten Mittelpunkts M2 vom negativen Ausgangsanschluss N auf den Verbindungspunkt V und umgekehrt (oder wahlweise des ersten Mittelpunkts M1 vom negativen Ausgangsanschluss N auf den Verbindungspunkt V und umgekehrt), erfolgt vorzugsweise über einen, z.B. von der Umschalteinheit 7 gesteuerten, ersten Umschalter R1, wobei in der dargestellten Ausführung der Verbindungspunkt V mit Masse verbunden ist und der erste Umschalter R1 den negativen Ausgangsanschluss N vom zweiten Mittelpunkt trennt und auf Masse schaltet.

Im zweiten Betriebsmodus Mu ist der zweite Mittelpunkt M2 mit dem negativen Ausgangsanschluss N verbunden und vom Verbindungspunkt V getrennt (was hier auch über den ersten Umschalter R1 erfolgt) um die erste Halbbrücke HB1 und die zweite Halbbrücke HB2 in Serie zu schalten und am Signalausgang ein Prüfsignal mit einer hohen Prüfspannung ua auszugegeben.

Natürlich ist diese Ausführung des ersten Umschalters R1, welcher zwei Funktionen realisiert (Trennen des negativen Ausgangsanschluss N vom zweiten Mittelpunkt M2, sowie Schalten des zweiten Mittelpunkts M2 auf Masse), wie auch die Ausführung des zweiten Umschalters R2, welcher ebenso mehrere Funktionen (Zuschalten/Überbrücken der Filterinduktivität Lx und Verbinden des ersten und zweiten Mittelpunkts M1, M2) jeweils eine bevorzugte. Es kann stattdessen auch beispielsweise je ein Umschalter für jede Funktion vorgesehen sein, z.B. ein Umschalter zum Zuschalten (oder Umschalten) der Filterinduktivität Lx, ein Umschalter zum Verbinden des ersten und zweiten Mittelpunkts M1, M2, ein Umschalter zum Zuschalten der Filterkapazität Cx, ein Umschalter zum Trennen des zweiten Mittelpunkt M2 vom negativen Ausgangsanschluss, ein Umschalter zum Schalten des zweiten Mittelpunkts M2 auf Masse - oder eine beliebige Kombination daraus.

In Fig. 3a ist die Verschaltung des Verstärkers 8 aus Fig. 2 im ersten Betriebsmodus Mi dargestellt. Der erste Umschalter R1 (nicht eingezeichnet) verbindet den negativen Ausgangsanschluss N mit dem Verbindungspunkt V (d.h. schaltet hier sowohl den negativen Ausgangsanschluss N, als auch den Verbindungspunkt V gegen Masse) und trennt den Ausgangsanschluss N vom zweiten Mittepunkt M2.

Der zweite Umschalter R2 (nicht eingezeichnet) schaltet im ersten Betriebsmodus Mi die Halbbrücken HB1, HB2 parallel, überbrückt hier ebenso die Filterkapazität Cx, und verbindet den ersten Mittelpunkt M1 mit dem zweiten Mittelpunkt M2 (jeweils über die Spulen L'). Der zweite Umschalter R2 ist in einer Stellung, in welcher die Filterinduktivität Lx zwischen den ersten Mittelpunkt M1 und den positiven Ausgangsanschluss P zu schalten. Der dritte Umschalter R3 ist geöffnet, um die Filterinduktivität Lx nicht zu brücken. Durch die Parallelschaltung der Halbbrücken HB1, HB2 kann im ersten Betriebsmodus Mi am Signalausgang der Prüfstrom ia des Prüfsignals verdoppelt werden. Können beispielsweise in den Halbbrücken HB1, HB2 verwendete Schaltelemente S1, S2, S3, S4 (beispielsweise als Transistoren ausgeführt) jeweils 15A standhalten, so ist durch eine Parallelschaltung zweier Halbbrücken HB1, HB2 eine Ausgabe eines Prüfsignals mit einem hohen Prüfstrom ia, z.B. im Bereich von 30A möglich. Werden weitere Halbbrücken zu den beiden Halbbrücken HB1, HB2 parallelgeschaltet, so kann ein Prüfsignal mit einem noch höheren Prüfstrom ia erzeugt werden.

Das erste Schaltelement S1 und das zweite Schaltelement S2 der ersten Halbbrücke HB1 schalten jeweils abwechselnd, ebenso schalten das dritte Schaltelement S3 und das vierte Schaltelement S4 der zweiten Halbbrücke HB2 jeweils abwechselnd. Ist das erste Schaltelement S1 aktiv, so ist das zweite Schaltelement S2 inaktiv - und umgekehrt. Ebenso ist das dritte Schalelement S3 aktiv, wenn das vierte Schaltelement S4 inaktiv ist - und umgekehrt. Der Tastgrad beschreibt bekanntermaßen das Verhältnis der Steuersignale der Schaltelemente S1, S2, S3, S4 einer Halbbrücke HB1, HB2, d.h. hier das Verhältnis der Steuersignale des ersten Schaltelements S1 zum zweiten Schaltelement S2 für die erste Halbbrücke HB1 und das das Verhältnis der Steuersignale des dritten Schaltelements S3 zum vierten Schaltelement S4 für die zweite Halbbrücke HB2. Vorzugsweise werden die erste Halbbrücke HB1 und die zweite Halbbrücke HB2 mit dem selben Tastgrad angesteuert.

Die Steuersignale werden von einer Pulsgenerationseinheit erzeugt. Vorzugsweise ist die Umschalteinheit 7 integraler Bestandteil der Pulsgenerationseinheit.

Im ersten Betriebsmodus Mi werden die erste Halbbrücke HB1 und die zweite Halbbrücke HB2 vorzugsweise um 180° versetzt angesteuert, womit sich für von den Halbbrücken HB1, HB2 gelieferten Halbbrückenausgangsströme i1, i2 jeweils (dreieckförmige) Rippelströme ergeben, die um 180° zueinander verschoben sind. Der Prüfstrom ia des Prüfsignals ergibt sich aus der Summe der Halbbrückenausgangsströme i1, i2. Dabei löschen sich bei einem Tastgrad von 50% die Rippelströme der beiden Halbbrückenausgangsströme i1, i2 aus. Bei Tastgraden ungleich 50% löschen sich die Rippelstrome der Halbbrückenausgangsströme i1, i2 nicht vollständig, jedoch teilweise aus. In Fig. 3a wird im ersten Betriebsmodus Mi der Prüfstom ia des Prüfsignals geregelt.

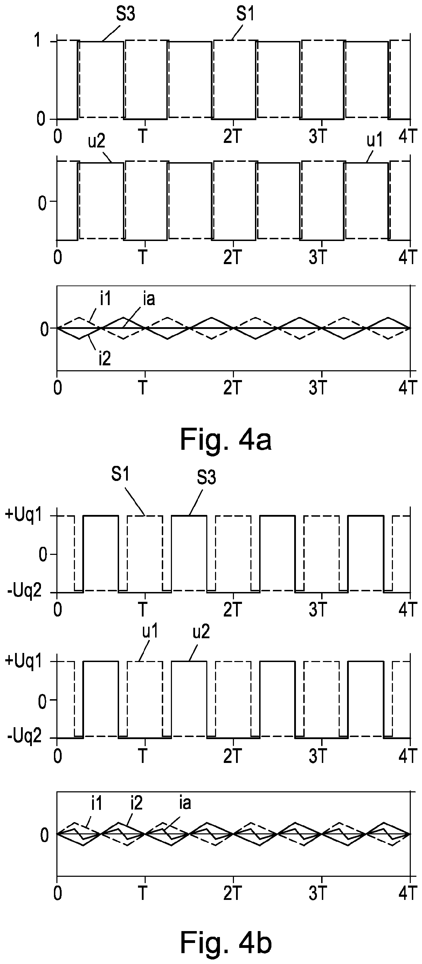

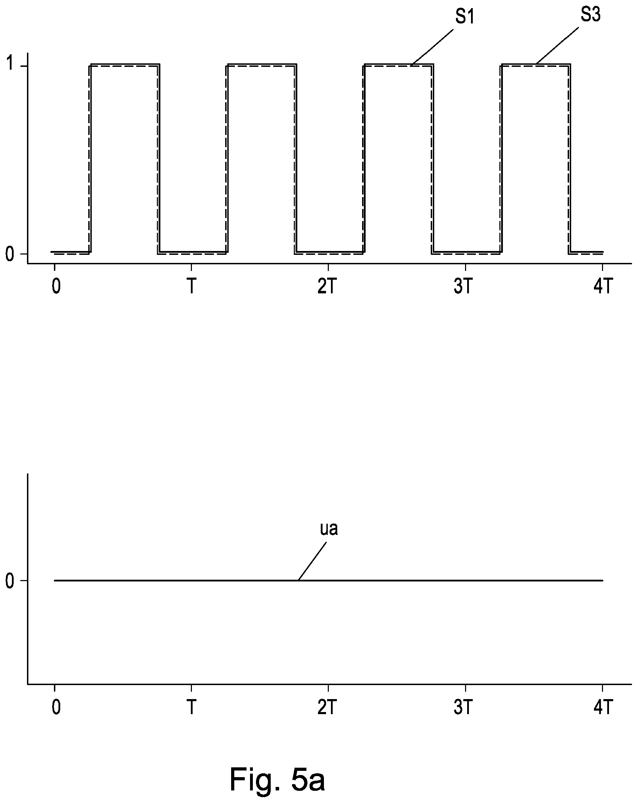

Fig. 4a sind für den ersten Betriebsmodus Mi im oberen Graphen beispielhaft die Steuersignale für das erste Schaltelement S1 und das dritte Schaltelement S3 mit einem Tastgrad von 50% und um 180° zueinander verschoben dargestellt. Der dargestellte leichte Versatz der Steuersignale dient lediglich dazu, die überlappenden Steuersignale in den Figuren optisch voneinander unterscheiden zu können. Es ist für das Steuersignal eine Schaltperiode T vorgesehen. Entsprechend sind im mittleren Graphen das daraus resultierende Spannungssignal u1 am ersten Mittelpunkt M1 und das resultierende Spannungssignal u2 am zweiten Mittelpunkt M3 dargestellt. Aus den Spannungssignalen u1, u2 resultieren wiederum der erste Halbbrückenausgangsstrom i1 in der mit dem ersten Mittelpunkt M1 verbundenen Leitungsfilterinduktivität L` und der zweite Halbbrückenausgangsstrom i2 in der mit dem zweiten Mittelpunkt M2 verbundenen Leitungsfilterinduktivität L`. Daraus ergibt sich der Prüfstrom ia des Prüfsignals als Summenstrom aus den Halbbrückenausgangsströmen i1, i2, wobei im in Fig. 5a dargestellten Fall im Prüfsignal kein Rippelstrom auftritt.

In Fig. 4b sind die Steuersignale für das erste Schaltelement S1 und das zweite Schaltelement S3 mit einem Tastgrad von 40% (abermals um 180° zueinander verschoben) dargestellt. Der Rippelstrom des Prüfstroms ia ist hier nicht mehr Null, weist jedoch gegenüber der Frequenz der Steuersignale eine doppelte Frequenz auf, wobei auch die Amplitude des Rippelstroms abgeschwächt wird.

In Fig. 3b ist die Verschaltung des Verstärkers 8 aus Fig. 2 im zweiten Betriebsmodus Mu dargestellt. Der erste Umschalter R1 (nicht eingezeichnet) verbindet den negativen Ausgangsanschluss N mit dem zweiten Mittelpunkt M2 und trennt den negativen Ausgangsanschluss N vom Verbindungspunkt V (d.h. hier von der Masse). Zudem ist hier im zweiten Betriebsmodus Mu die Filterkapazität Cx zwischen dem positiven Ausgangsanschluss P und negativen Ausgangsanschluss N geschaltet, da der zweite Umschalter R2 die Filterkapazität Cx nicht überbrückt. Der zweite Umschalter R2 überbrückt hier jedoch die Filterinduktivität Lx. In Fig. 3b wird im zweiten Betriebsmodus Mu die Prüfspannung ua des Prüfsignals geregelt.

Fig. 3c stellt ebenso den zweiten Betriebsmodus Mu dar, der sich jedoch vom zweiten Betriebsmodus Mu entsprechend Fig. 4b dadurch unterscheidet, dass der dritte Umschalter R3 geöffnet ist und dafür sorgt, dass die Filterinduktiviät Lx nicht überbrückt wird. In Fig. 3c wird im zweiten Betriebsmodus Mu der Prüfstrom ia des Prüfsignals geregelt. Damit ist es möglich im zweiten Betriebsmodus Mu einen Prüfstrom mit einer hohen Signalqualität und einem robusten Regelverhalten auf niederohmige, wie auch hochohmige Lasten Z auszugeben.

Es ist natürlich auch möglich, jedoch nicht in den Figuren dargestellt, die Prüfspannung im ersten Betriebsmodus Mi zu regeln. In folgender Tabelle wird kurz beschrieben, welche Figuren welche Betriebsmodi Mi, Mu und welche Regelungsarten (Regelung des Prüfstroms ia, Regelung der Prüfspannung ua) darstellen:

| | Erster Betriebsmodus Mi | Zweiter Betriebsmodus Mu |
|---|---|---|
| Regelung des Prüfstroms ia | Fig. 3a | Fig.3c |
| Regelung der Prüfspannung ua | (nicht dargestellt) | Fig.3b |

In Fig. 5a sind die Steuersignale für das erste Schaltelement S1 und das zweite Schaltelement S2 im zweiten Betriebsmodus Mu dargestellt. Der leichte Versatz der dargestellten Steuersignale dient dazu, um die Steuersignale in den Figuren optisch voneinander unterscheiden zu können. Es ist in Fig. 5a ein Tastgrad 50% dargestellt, was bedeutet, dass die Steuersignale in Phase zueinander sind. Die Halbbrückenausgangsspannungen u1, u2 am ersten und zweiten Mittelpunkt M1, M2 haben die gleiche Form, wie die Steuersignale, womit sich die Stromrippel der durch die Leitungsfilterinduktivität L' fließenden Spulenströme kompensiert. Das Spannungssignal ua ergibt sich aus der Differenz der Halbbrückenspannungen u1 u2, womit sich im dargestellten Fall kein Spannungsrippel auftritt, sondern sich eine Prüfspannung ua von Null einstellt.

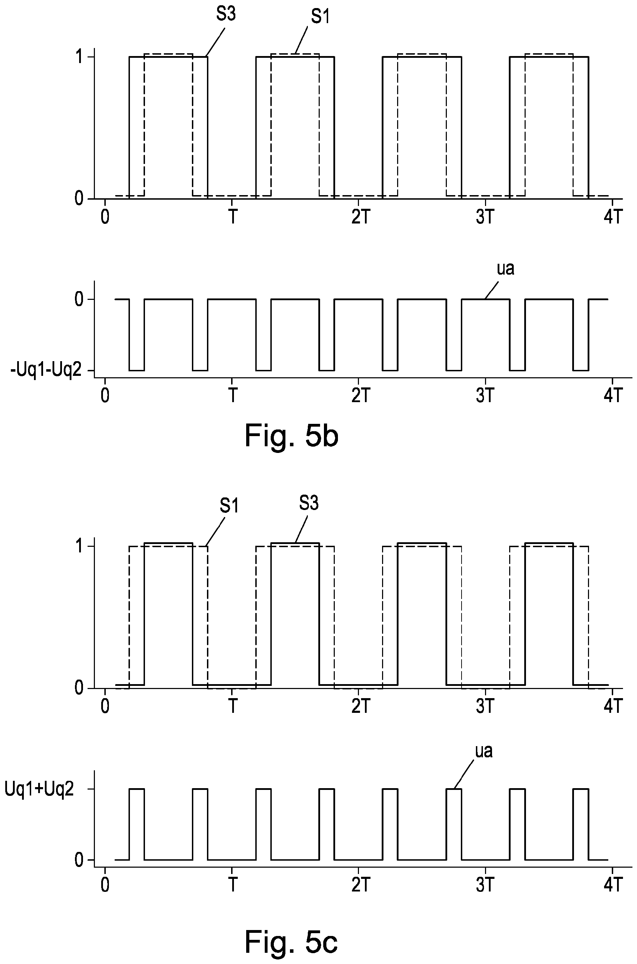

In Fig. 5b ist ein Tastgrad von 40%, wogegen in Fig. 5c ein Tastgrad von 60% dargestellt ist. Es ergibt sich somit eine Prüfspannung ua, (abermals aus der Differenz der Halbbrückenspannungen u1, u2) welches die doppelte Frequenz der Steuersignale aufweist. Damit löschen sich die Stromrippel der durch die Leitungsfilterinduktivität L' fließenden Spulenströme in Summe halb aus, womit und in weiterer Folge durch die doppelte Frequenz der Steuersignale der Spannungsrippel der Prüfspannung ua an der Filterkapazität Cx halbiert wird.

## Patentansprüche

1. Verstärker (8) für ein Prüfgerät (10), welches zum Prüfen einer elektrischen Komponente geeignet ist, wobei der Verstärker (8) ausgestaltet ist, ein Prüfsignal an einem Signalausgang zwischen einem positiven Ausgangsanschluss (P) und einen negativen Ausgangsanschluss (N) auszugeben, und wobei der Verstärker (8) eine erste Halbbrücke (HB1), welche ein erstes Schaltelement (S1) und ein über einen ersten Mittelpunkt (M1) mit dem ersten Schaltelement (S1) in Serie geschaltetes zweites Schaltelement (S2) aufweist, und eine zweite Halbbrücke (HB2), welche ein drittes Schaltelement (S3) und ein über einen zweiten Mittelpunkt (M2) mit dem dritten Schaltelement (S3) in Serie geschaltetes viertes Schaltelement (S4) aufweist, umfasst,
wobei eine Umschalteinheit (7) vorgesehen ist, welche ausgestaltet ist, in einem ersten Betriebsmodus (Mi) den ersten Mittelpunkt (M1) der ersten Halbbrücke (HB1) mit dem zweiten Mittelpunkt (M2) der zweiten Halbbrücke (HB2) zu verbinden und auf einen der Ausgangsanschlüsse (P, N) des Signalausgangs zu schalten, und in einem zweiten Betriebsmodus (Mu) den ersten Mittelpunkt (M1) der ersten Halbbrücke (HB1) und den zweiten Mittelpunkt (M2) der zweiten Halbbrücke (HB2) auf jeweils einen der Ausgangsanschlüsse (P, N) des Signalausgangs zu schalten, **und** wobei
der Verstärker (8) weiterhin ausgestaltet ist, im ersten Betriebsmodus (Mi) der ersten Halbbrücke (HB1) mit Steuersignalen anzusteuern, welche gegenüber Steuersignalen zur Ansteuerung der zweiten Halbbrücke (HB2) um 180 Grad phasenverschoben sind, und im zweiten Betriebsmodus (Mu) die ersten Halbbrücke (HB1) und die zweiten Halbbrücke (HB2) mit phasengleichen Steuersignalen anzusteuern.

2. Verstärker (8) nach Anspruch 1, **dadurch gekennzeichnet, dass** der Verstärker (8) eine erste Gleichspannungsquelle (UQ1) und eine über einen Verbindungspunkt (V) in Serie geschaltete zweite Gleichspannungsquelle (UQ2) umfasst, wobei die erste und zweite Halbbrücke (HB1, HB2) jeweils parallel zu den in Serie geschalteten ersten und zweiten Gleichspannungsquellen (UQ1, UQ2) geschaltet sind.

3. Verstärker (8) nach Anspruch 2, **dadurch gekennzeichnet, dass** im ersten Betriebsmodus (Mi) der erste Mittelunkt (M1) mit dem positiven Ausgangsanschluss (P) verbunden ist, und der zweite Mittelpunkt (M2) mit dem positiven Ausgangsanschluss (P) verbunden und vom negativen Ausgangsanschluss (N) getrennt ist, sowie der Verbindungspunkt (V) mit dem negativen Ausgangsanschluss (N) verbunden ist.

4. Verstärker (8) nach Anspruch 2, **dadurch gekennzeichnet, dass** im zweiten Betriebsmodus (Mu) der erste Mittelpunkt (M1) mit dem positiven Ausgangsanschluss (P) verbunden ist und der zweite Mittelpunkt (M2) vom Verbindungspunkt (V) getrennt und mit dem negativen Ausgangsanschluss (N) verbunden ist.

5. Verstärker (8) nach Anspruch 4, **dadurch gekennzeichnet, dass** im zweiten Betriebsmodus (Mu) die Verbindung des zweiten Mittelpunkts (M2) mit dem negativen Ausgangsanschluss (N) über einen ersten Umschalter (R1), welcher von der Umschalteinheit (7) angesteuert wird, erfolgt.

6. Verstärker (8) nach einem der Ansprüche 1 bis 5, **dadurch gekennzeichnet, dass** eine Filterkapazität (Cx) vorgesehen ist, welche, vorzugsweise im zweiten Betriebsmodus (Mu), zwischen den positiven Ausgangsanschluss (P) und den negativen Ausgangsanschluss (N) schaltbar ist.

7. Verstärker (8) nach einem der Ansprüche 1 bis 6, **dadurch gekennzeichnet, dass** am Signalausgang eine Filterinduktivität (Lx) vorgesehen ist, die eine, vorzugsweise durch die Umschalteinheit (7), umschaltbare und/oder überbrückbare, Induktivität aufweist.

8. Prüfgerät (10) zum Prüfen einer elektrischen Komponente, vorzugsweise einer Steuervorrichtung (6) einer Schaltvorrichtung (5) einer elektrischen Schaltanlage (4), umfassend einen Verstärker (8) nach einem der Ansprüche 1 bis 7, welcher das Prüfsignal zum Prüfen der elektrischen Komponente ausgibt.

## Claims

1. Amplifier (8) for a test device (10) for testing an electrical component, wherein the amplifier (8) is designed to output a test signal at a signal output between a positive output terminal (P) and a negative output terminal (N), and wherein the amplifier (8) comprises a first half bridge (HB1), which has a first switching element (S1) and a second switching element (S2) connected in series with the first switching element (S1) via a first center point (M1), and a second half bridge (HB2), which has a third switching element (S3) and a fourth switching element (S4) connected in series with the third switching element (S3) via a second center point (M2), **wherein** a switching unit (7) is provided, which is designed to connect the first center point (M1) of the first half bridge (HB1) to the second center point (M2) of the second half bridge (HB2) and to connect to one of the output terminals (P, M) of the signal output in a first operating mode (Mi), and to connect each of the first center point (M1) of the first half bridge (HB1) and the second center point (M2) of the second half bridge (HB2) to one of the output terminals (P, N) of the signal output in a second operating mode (Mu), and **wherein** the amplifier (8) is further designed, in the first operating mode (Mi), to control the first half bridge (HB1) with control signals, which are phase-shifted by 180 degrees with respect to the control signals for controlling the second half bridge (HB2), and to control the first half bridge (HB1) and the second half bridge (HB2) with in-phase control signals in the second operating mode (Mu).

2. Amplifier (8) according to claim 1, **characterized in that** the amplifier (8) comprises a first DC voltage source (UQ1) and a second DC voltage source (UQ2) connected in series via a connection point (V), wherein the first half-bridge (HB1) and second half bridge (HB2) are each connected in parallel to the series-connected first and second DC voltage sources (UQ1, UQ2).

3. Amplifier (8) according to claim 2, **characterized in that,** in the first operating mode (Mi), the first center point (M1) is connected to the positive output terminal (P), and the second center point (M2) is connected to the positive output terminal (P) and is disconnected from the negative output terminal (N), and the connection point (V) is connected to the negative output terminal (N).

4. Amplifier (8) according to claim 2, **characterized in that,** in the second operating mode (Mu), the first center point (M1) is connected to the positive output terminal (P), and the second center point (M2) is disconnected from the connection point (V) and connected to the negative output terminal (N).

5. Amplifier (8) according to claim 4, **characterized in that**, in the second operating mode (Mu), the second center point (M2) is connected to the negative output terminal (N) by a first switch (R1) which is actuated by the switching unit (7).

6. Amplifier (8) according to one of claims 1 to 5, **characterized in that** a filter capacitor (Cx) is provided, which is switchable between the positive output terminal (P) and the negative output terminal (N) - preferably in the second operating mode (Mu).

7. Amplifier (8) according to one of claims 1 to 6, **characterized in that** a filter inductor (Lx) is provided at the signal output and has an inductor which can be switched and/or bridged - preferably by the switching unit (7).

8. Test device (10) for testing electrical components - preferably a control device (6) of a switching device (5) of an electrical switchgear (4) - comprising an amplifier (8) according to one of claims 1 to 7 which outputs the test signal for testing the electrical components.

## Revendications

1. Amplificateur (8) pour un appareil de test (10) adapté pour tester un composant électrique, dans lequel l'amplificateur (8) est configuré pour émettre un signal de test à une sortie de signal entre une borne de sortie positive (P) et une borne de sortie négative (N), et dans lequel l'amplificateur (8) comprend un premier demi-pont (HB1), lequel présente un premier élément de commutation (S1) et un deuxième élément de commutation (S2) monté en série avec le premier élément de commutation (S1) par l'intermédiaire d'un premier point central (M1), et un second demi-pont (HB2), lequel présente un troisième élément de commutation (S3) et un quatrième élément de commutation (S4) monté en série avec le troisième élément de commutation (S3) par l'intermédiaire d'un second point central (M2),
dans lequel une unité de commutation (7) est prévue, laquelle est configurée pour connecter, dans un premier mode de fonctionnement (Mi), le premier point central (M1) du premier demi-pont (HB1) au second point central (M2) du second demi-pont (HB2) et pour les commuter sur l'une des bornes de sortie (P, N) de la sortie de signal et, dans un second mode de fonctionnement (Mu), pour commuter le premier point central (M1) du premier demi-pont (HB1) et le second point central (M2) du second demi-pont (HB2) sur respectivement l'une des bornes de sortie (P, N) de la sortie de signal, et dans lequel
l'amplificateur (8) est en outre configuré pour commander, dans le premier mode de fonctionnement (Mi), le premier demi-pont (HB1) avec des signaux de commande qui sont déphasés de 180 degrés par rapport à des signaux de commande permettant de commander le second demi-pont (HB2) et, dans le second mode de fonctionnement (Mu), pour commander le premier demi-pont (HB1) et le second demi-pont (HB2) avec des signaux de commande à phase égale.

2. Amplificateur (8) selon la revendication 1, **caractérisé en ce que** l'amplificateur (8) comprend une première source de tension continue (UQ1) et une seconde source de tension continue (UQ2) montée en série par l'intermédiaire d'un point de connexion (V), dans lequel les premier et second demi-ponts (HB1, HB2) sont respectivement montés parallèlement aux première et seconde sources de tension continue (UQ1, UQ2) montées en série.

3. Amplificateur (8) selon la revendication 2, **caractérisé en ce que,** dans le premier mode de fonctionnement (Mi), le premier point central (M1) est connecté à la borne de sortie positive (P) et le second point central (M2) est connecté à la borne de sortie positive (P) et séparé de la borne de sortie négative (N) et le point de connexion (V) est connecté à la borne de sortie négative (N).

4. Amplificateur (8) selon la revendication 2, **caractérisé en ce que,** dans le second mode de fonctionnement (Mu), le premier point central (M1) est connecté à la borne de sortie positive (P)
et le second point central (M2) est séparé du point de connexion (V) et connecté à la borne de sortie négative (N).

5. Amplificateur (8) selon la revendication 4, **caractérisé en ce que,** dans le second mode de fonctionnement (Mu), la connexion du second point central (M2) à la borne de sortie négative (N) est effectuée par l'intermédiaire d'un premier commutateur (R1) commandé par l'unité de commutation (7).

6. Amplificateur (8) selon l'une des revendications 1 à 5,
**caractérisé en ce qu'**une capacité de filtrage (Cx) est prévue, laquelle peut être commutée, de préférence dans le second mode de fonctionnement (Mu), entre la borne de sortie positive (P) et la borne de sortie négative (N).

7. Amplificateur (8) selon l'une des revendications 1 à 6,
**caractérisé en ce qu'**une inductance de filtrage (Lx) est prévue au niveau de la sortie de signal, laquelle inductance de filtrage présente une inductance pouvant être commutée et/ou pontée, de préférence par l'unité de commutation (7).

8. Appareil de test (10) permettant de tester un composant électrique, de préférence un dispositif de commande (6) d'un dispositif de commutation (5) d'une installation de commutation électrique (4), comprenant un amplificateur (8) selon l'une des revendications 1 à 7, lequel émet le signal de test pour le test du composant électrique.
